# EUROPEAN PATENT APPLICATION

(11) **EP 1 925 419 A1**
(43) Date of publication of application: **28.05.2008**
(21) Application number: 06077073.2
(22) Date of filing: 22.11.2006
(51) Int. Cl.: B29C 45/17, B01L 3/00, B81C 1/00

(54) **Product having a solid body and inside hollow rooms**

(71) Applicant: Nederlandse Organisatie voor Toegepast-Natuurwetenschappelijk Onderzoek TNO, 2628 VK Delft (NL)
(72) Inventor: de Zwart, Renatus Marius, 5655 JP Eindhoven (NL); Kunen, Joseph Mathias Gerardus, 3123 PN Schiedam (NL)
(74) Representative: van Loon, C.J.J.

(57) **Abstract**

Method and system for making a product (1) having a solid body (2) and having hollow rooms (3) inside that solid body. The system comprises means for providing a liquid material within a mould (4), means (5,9) for controlled solidifying the liquid material excluding said intended hollow rooms and means (7) for driving out the liquid material within said intended hollow rooms. When using a thermoplastic material, the system may include means (5,9) for controlled cooling said liquid material excluding said intended hollow rooms, below the melting point. When using a thermosetting material the system may include means (5,9) for controlled heating the liquid material, excluding said intended hollow rooms. Moreover, means (6) are provided for driving out the liquid material within said intended hollow rooms by means of air or another gaseous medium or by means of water or another liquid medium.

## Description

### Field of the invention

The invention relates to products which have a solid body and hollow rooms inside the body. The invention may especially - but not exclusively - relate to microfluidic components. The hollow rooms may include process rooms or chambers etc., inlet, outlet or connention channels etc.

### Background of the invention

Lab-on-a-chip (LOC) is a term for devices that integrate (multiple) laboratory functions on a single chip of only square millimeters to a few square centimeters in size and that are capable of handling extremely small fluid volumes down to less than pico liters. Lab-on-a-chip devices are a subset of MEMS devices and often indicated by "Micro Total Analysis Systems" (µTAS) as well. Microfluidics is a broader term that describes also mechanical flow control devices like pumps and valves or sensors like flowmeters and viscometers. However, strictly regarded "Lab-on-a-Chip" indicates generally the scaling of single or multiple lab processes down to chip-format, whereas "µTAS" is dedicated to the integration of the total sequence of lab processes to perform chemical analysis. The term "Lab-on-a-Chip" was introduced later on when it turned out that µTAS technologies were more widely applicable than only for analysis purposes.

After the discovery of microtechnology (-1958) for realizing integrated semiconductor structures for microelectronic chips, these lithography-based technologies were soon applied in pressure sensor manufacturing (1966) as well. Due to further development of these usually CMOS-compatibility limited processes, a tool box became available to create micrometre or sub-micrometre sized mechanical structures in silicon wafers as well: the Micro Electro Mechanical Systems (MEMS) era (also indicated with Micro System Technology - MST) had started.

Next to pressure sensors, airbag sensors and other mechanically movable structures, fluid handling devices were developed. Examples are: channels (capillary connections), mixers, valves, pumps and dosing devices. The first LOC analysis system was a gas chromatograph, developed in 1975 by S.C. Terry - Stanford University. However, only at the end of the 1980's, and beginning of the 1990's, the LOC research started to seriously grow as a few research groups in Europe developed micropumps, flowsensors and the concepts for integrated fluid treatments for analysis systems. These µTAS concepts demonstrated that integration of pre-treatment steps, usually done at lab-scale, could extend the simple sensor functionality towards a complete laboratory analysis, including e.g. additional cleaning and separation steps.

A big boost in research and commercial interest came in the mid 1990's, when µTAS technologies turned out to provide interesting tooling for genomics applications, like capillary electrophoresis and DNA microarrays. A big boost in research support also came from the military, especially from DARPA (Defense Advanced Research Projects Agency), for their interest in portable bio/chemical warfare agent detection systems. The added value was not only limited to integration of lab processes for analysis but was extended to the characteristic possibilities of individual components and the application to other, non-analysis, lab processes. Hence the term "Lab-on-a-Chip" was introduced.

Although the application of LOCs is still novel and modest, a growing interest of companies and applied research groups is observed in different fields such as analysis (e.g. chemical analysis, environmental monitoring, medical diagnostics and cellomics) but also in chemistry (e.g. rapid screening and microreactors for pharmaceutics). Besides further application developments, research in LOC systems is expected to extend towards downscaling of fluid handling structures as well, by using nanotechnology. Sub-micrometre and nano-sized channels, DNA labyrinths, single cell detection and analysis and nano-sensors might become feasible that allow new ways of interaction with biological species and large molecules. One commercially very successful example for LOCs in life science is the developement of automated patch clamp chips, that allowed for drastically increased throughput for drug screening in the pharmaceutical industry.

The basis for most LOC fabrication processes is lithography. Initially most processes were in silicon, as these well-developed technologies were directly derived from semiconductor fabrication. Because of demands for e.g. specific optical characteristics, bio- or chemical compatibility, lower production costs and faster prototyping, new processes have been developed such as glass, ceramics and metal etching, deposition and bonding, PDMS processing (e.g. soft lithography), thick-film- and stereolithography as well as fast replication methods via electroplating, injection molding and embossing. Furthermore the LOC field more and more crosses the borders between lithography-based microsystem technology, nano technology and precision engineering.

Typical advantages of LOCs are:
- low fluid volumes consumption, because of the low internal chip volumes, which is beneficial for e.g. environmental pollution (less waste), lower costs of expensive reagents and less sample fluid is used for diagnostics
- higher analysis and control speed of the chip and better efficiency due to short mixing times (short diffusion distances), fast heating (short distances, high wall surface to fluid volume ratios, small heat capacities)
- better process control because of a faster response of the system (e.g. thermal control for exothermic chemical reactions)
- compactness of the systems, due to large integration of functionality and small volumes
- massive parallelization due to compactness, which allows high-throughput analysis
- lower fabrication costs, allowing cost-effective disposable chips, fabricated in mass production
- safer platform for chemical, radioactive or biological studies because of large integration of functionality and low stored fluid volumes and energies

### Disadvantages of LOCs are:

- novel technology and therefore not fully developed yet physical effects like capillary forces and chemical effects of channel surfaces become more dominant and make LOC systems behave differently and sometimes more complex than conventional lab equipment
- detection principles may not always scale down in a positive way, leading to low signal to noise ratios.

One specific problem concerns the manufacture of channels and/or processing or reaction chambers within the "chips", which hereinafter will be indicated as (processing) modules. Prior art processing modules may be made of a thermoplastic or a thermosetting synthetic resin in which channels and reaction chambers are made from the upper and/or lower side, e.g. by means of moulding or by means of machining, after which the channels and chambers are closed by means of a cover layer which e.g. is sealed, bonded or laser-welded to the reaction module, thus forming interior channels and chambers. This method, however may introduce a certain level of contamination in the fluidic channels and chambers and, moreover, is more expensive.

### Summary of the invention

One aim of the invention is to present a method which is more reliable and provides more reliable processing modules. Another aim is to provide much cheaper processing modules.

Preferably the new method for making a product - e.g. LOC type processing modules etc. - having a solid body and having hollow rooms inside that solid body may comprise steps of:
- providing a liquid material within a mould;
- controlled solidifying - i.e. making or allowing to become hard or solid, or changing from liquid to solid state - said liquid material excluding said intended hollow rooms;
- driving out the liquid material within said intended hollow rooms.

When the material is a thermoplastic material which is liquid above its melting point, the material in the mould can be solidified in a controlled way by means of controlled cooling said liquid material excluding said intended hollow rooms, below said melting point.

When the material is a thermosetting material which is liquid before curing, the material in the mould can be solidified in a controlled way by means of controlled curing said liquid material, excluding said intended hollow rooms.

In the next chapter examples will be given and discussed in what way and by what means the controlled solidification may be performed.

After the intended solid areas are solidified, the material within said intended hollow rooms, which is still liquid, may be driven out by means of air or another gaseous medium. As an alternative the liquid material within said intended hollow rooms may be driven out by means of water or another liquid medium.

Below the method will be discussed with the help of some illustrated examples.

### Exemplary Embodiment

Figure 1 shows two cross-sectional views of an example of a LOC chip or module which can be made by the method according to the invention.
Figure 2 shows five views of the construction of an exemplary embodiment of a configuration in which the method according to the invention may be performed to produce the product shown in figure 1.
Figure 3 shows a detail of the configuration shown in figure 2.
Figure 4 shows an alternative way of controlled and selective energy supply for the selective conversion of a liquid into a solid mass.
Figure 5 shows an alternative for the embodiment of figure 4.

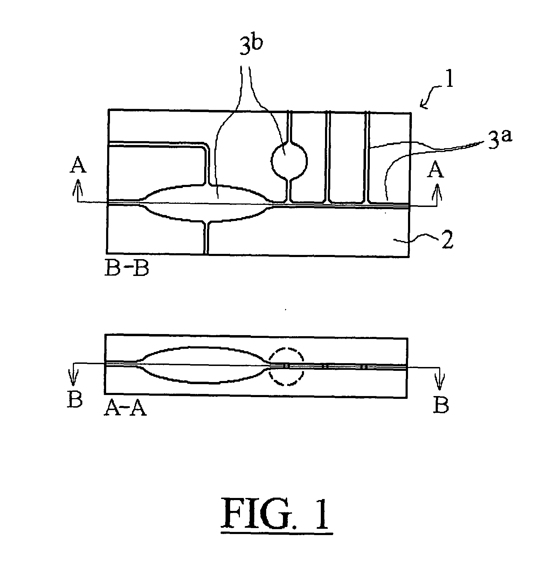

Figure 1 shows a product 1 - e.g. a LOC chip - having a solid body 2 of solidified material and hollow rooms 3, viz. channels 3a and processing rooms 3b - inside that solid body 2.

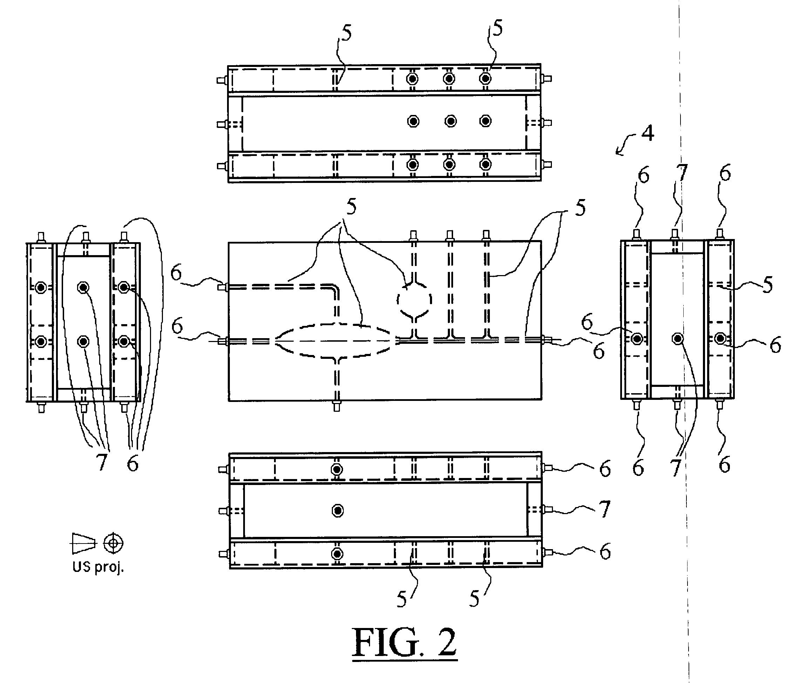

The product 1 is made in a mould 4, shown in figure 2, in which a liquid material is entered, e.g. a molten thermoplastic material (e.g. sysnthetic resin) or a mixture of a liquid, curable thermosetting material.

The production configuration, represented by the mould 4 comprises means for controlled solidifying the synthetic material, excluding said intended hollow rooms. Those means are represented by heating (for thermoplastics) or cooling (for thermosetting materials) channels 5 which have about the same shape as the intended hollow channels 3a and rooms 3b in the product 1 to be formed in the mould 4. It will be presumed that the mould - excluding the channels 5 - will be brought at a temperature which is fit to solidify the liquid material after being brought into the mould.

When the product is to be made of a thermoplastic, solidification occurs by cooling the liquid material in the mould. In that case the mould 4 is cooled by cooling means (not shown explicitly). However the solidification process is retarded in the regions of the channels 5, viz. by means of a fluid (e.g. a thermic oil) which is pumped through those channels 5 via channel inlets and outlets 6 and which has a temperature which is higher than the remaining mould temperature. As the regions of the channels 5 - having the same shape as the intended channels/rooms 3a/b in thermoplastic mass within the mould 4 - thus get behind in the solidification and, moreover, the centre of the mass will always come behind the more outside regions of the mass, at a certain moment, by smart timing and temperature control of the liquid flowing through the temperature control channels 5, the condition can be reached that the outside regions of the mass inside the mould 4 and the regions which are not or less influenced by the higher temperature of the control channels 5 have become solid, while the regions in which the solidification has been retarded under the influence of the higher temperature of the control channels 5, and especially the inner parts thereof, are still liquid. At that very moment the liquid thermoplastic can be driven out of the surrounding solidified mass by means of a driving fluid (e.g. water) or gas (e.g. air) under pressure, via inlets and outlets 7.

After the liquid synthetic material has been blown out, the product - which is entirely solid and which comprises hollow channels, rooms etc. - can finish its solidification or curing process and finally be released out of the mould.

When the product is to be made of a thermosetting material, solidification occurs by thermal curing the liquid material in the mould. In that case the mould 4 is heated by heating means (not shown explicitly) to start curing of the thermosetting material. However the solidification (viz. curing) process is retarded in the regions of the channels 5, viz. by means of a fluid (e.g. a thermic oil) which is pumped through those channels 5 via channel inlets and outlets 6 and which has a temperature which is - in this case - lower than the remaining mould temperature. As the regions of the channels 5 - having about the same shape as the intended channels/rooms 3a/b in thermoplastic mass within the mould 4 - thus get behind in the curing and, moreover, the centre of the mass will always come behind the more outside regions of the mass, at a certain moment, by smart timing and temperature control of the liquid flowing through the temperature control channels 5, the condition can be reached that the outside regions of the mass inside the mould 4 and the regions which are not or less influenced by the lower temperature of the control channels 5 have become solid, while the regions in which the solidification has been retarded under the influence of the lower temperature of the control channels 5, and especially the inner parts thereof, are still liquid. At that very moment the still liquid (viz. not yet polymerized) thermosetting mass can be driven out of the surrounding already cured mass by means of a driving fluid (e.g. water) or gas (e.g. air) under pressure, via inlets and outlets 7.

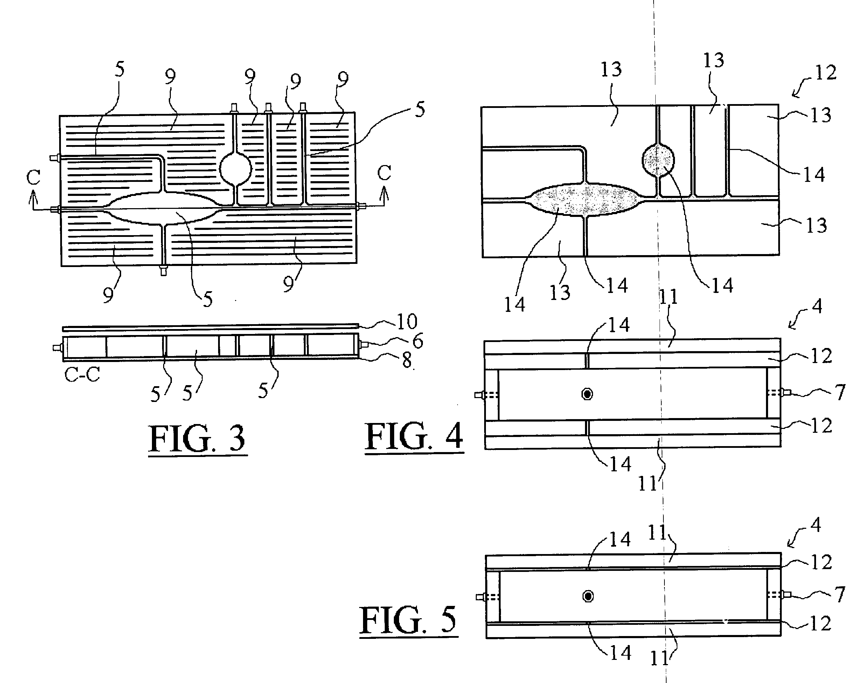

Finally, figure 3 shows schematically the construction of the upper and lower part of the mould 4, comprising a rather robust mould wall 8, having control channels 5 which open at one side and which e.g. are made by machining (e.g. by milling or spark erosion). In the areas between the channels 5 the mould wall is provided with cooling or heating channels or elements 9, which are activated to solidify or cure the material mass inside the mould 4 which has to become the solid part of the product (e.g. LOC chip), while - as explained in the preceding - the channels 5 act to retard the solidification speed, in order to be able to discriminate and to blow out - at the right moment - the intended channels and rooms 3 in the product 1.

After the inlets/outlets 6 are mounted, the half-open channels 5 are hermetically closed and sealed by a cover plate 10.

In the above exemplary embodiments the solidification is performed by means of controlled cooling/heating the respective areas which have to become solidified or not solidified respectively, which are embodied by means of cooling/heating channels 5 and elements 9. Figures 4 and 5 show alternative configurations.

Figure 4 shows an upper part and lower part of the mould 4 as shown in figure 2. In figure 4 the upper part and lower part both consist of a cooling element (when processing a thermoplastic mass within the mould for cooling it) or heating element (when processing a thermosetting mass within the mould for curing it) 11. Between the element 11 and the (liquid) mass inside the mould a mask member 12 is provided, which comprises heat conductive parts 13 (white) and heat isolating (or less conductive) parts 14 (grey), having a shape which approximately matches with the projection of the shape of the channels/rooms to be formed within the mass in the mould and thus within the final product to be made. Heat transfer between the mass inside the mould 4 and the elements 11, viz. to cool down the (thermoplastic) mass or to cure the (thermosetting) mass respectively is hampered by the isolation mask 14, causing local solidification delay in the areas covered by the heat isolating mask 14. Instead of the plate wise build up of the upper and lower parts in figure 4, the heating/cooling plate 11 and the mask member 12 may be integrated into one plate.

Curing of thermosetting materials may be performed by means of UV or other radiation. In that case element 11 is not a heat emitting element but a UV (or other) radiating element. In that case the mask member 12 comprises parts 13 which are suitable to pas UV (or other resp.) curing radiation, while the areas 14 are not or less permeable for the curing radiation emitted by the radiating elements 11, thus hampering the solidification (viz. by curing) of the material in the areas covered by the parts 14 and causing that those area remain longer liquid, which liquid areas can be blown out by a drive gas or drive liquid (e.g. water) via the inlets/outlets 7 in the side wall of the mould, as explained more in detail in the preceding. In practice UV mask 12 may be formed by a rather thin sheet, contrary to the heat isolating masking plate 12 as illustrated in figure 4. Figure 5 shows such a configuration using a thin UV mask 12, e.g. a sheet which is transparent for UV with the exception of a mask pattern (14) - as can be seen in the upper part of figure 4 - which is not transparent for UV radiation. The UV radiation level of the radiation sources 11 may be adjustable or (e.g. dynamically) controllable.

It is noted that both, more "active" heating/cooling means like the means 5 and 9 in the configuration of figure 2 and 3, and more "passive" heating/cooling means like the means 11 and 12 (incl. 13 and 14) may be used simultaneously if desired.

Concerning the blowing out process step, it may be desired to provide extra, auxiliary channels within the product to be made, viz. to provide effective blowing out the (still) liquid mass outwards the mould (via outlets 7). Such auxiliary channels may be filled or plugged before of after the product has been released out of the mould 4.

## Claims

1. Method for making a product having a solid body and having hollow rooms inside that solid body, comprising steps of:
- providing a liquid material within a mould;
- controlled solidifying said liquid material excluding said intended hollow rooms;
- driving out the liquid material within said intended hollow rooms.

2. Method according to claim 1, said material being a thermoplastic material which is liquid above its melting point and which is solidified in a controlled way by means of controlled cooling said liquid material excluding said intended hollow rooms, below said melting point.

3. Method according to claim 1, said material being a thermosetting material which is liquid before curing and which is solidified in a controlled way by means of controlled curing said liquid material, excluding said intended hollow rooms.

4. Method according to claim 1, the liquid material within said intended hollow rooms is driven out by means of air or another gaseous medium.

5. Method according to claim 1, the liquid material within said intended hollow rooms is driven out by means of water or another liquid medium.

6. System for making a product (1) having a solid body (2) and having hollow rooms (3) inside that solid body, comprising means for providing a liquid material within a mould (4), means (5,9) for controlled solidifying said liquid material excluding said intended hollow rooms, and means (7) for driving out the liquid material within said intended hollow rooms.

7. System according to claim 6, said material being a thermoplastic material, the system comprising means for solidifying the thermoplastic material in a controlled way and including means (5,9) for controlled cooling said liquid material excluding said intended hollow rooms, below said melting point.

8. System according to claim 6, said material being a thermosetting material, the system comprising means for curing the thermosetting material in a controlled way and including means (5,9) for controlled heating said liquid material, excluding said intended hollow rooms.

9. System according to claim 6, comprising means (6) for driving out the liquid material within said intended hollow rooms by means of air or another gaseous medium.

10. System according to claim 6, comprising means (6) for driving out the liquid material within said intended hollow rooms by means of water or another liquid medium.
